# EUROPEAN PATENT APPLICATION

(11) **EP 4 451 349 A1**
(43) Date of publication of application: **23.10.2024**
(21) Application number: 23874250.6
(22) Date of filing: 21.06.2023
(51) Int. Cl.: H01L 31/05, H01L 31/0224, F16B 11/00, C09J 7/10, C09J 7/38, C09J 123/08, C09J 129/14, H01L 31/0216, H01L 31/18, B32B 17/00, B32B 17/06, B32B 33/00

(54) **BUSBAR-FREE ASSEMBLY AND MANUFACTURING METHOD THEREFOR, AND METHOD FOR CONNECTING BATTERY TO SOLDER RIBBON**

(30) Priority: 08.10.2022 CN 202211220767; 11.11.2022 CN 202211410546; 11.11.2022 CN 202211410732; 11.11.2022 CN 202211410735
(71) Applicant: Zhejiang Znergy Solar Co., Ltd., Hangzhou, Zhejiang 310000 (CN)
(72) Inventor: DENG, Shifeng, Hangzhou, Zhejiang 310000 (CN); SHI, Lei, Hangzhou, Zhejiang 310000 (CN)
(74) Representative: Hautier IP - MC/EP
(86) International application number: PCT/CN2023/101930
(87) International publication number: WO 2024/074056

(57) **Abstract**

Disclosed in the present invention are a busbar-free assembly and a manufacturing method therefor, and a method for connecting a battery to a solder ribbon. The busbar-free assembly comprises a battery, a solder ribbon arranged on the battery, an adhesive film covering the solder ribbon, and a cover plate covering the adhesive film, and further comprises a bonding mechanism arranged between the solder ribbon and the battery, wherein the bonding mechanism is transparent, so as to increase light transmittance. The battery and the solder ribbon are connected by means of an adhesive, the adhesive is coated on an inner end surface of the adhesive film, and the adhesive film corresponds to the battery in terms of size, thereby achieving the fixation of the solder ribbon and the battery, omitting a carrier, increasing light transmittance, improving generated power, and also preventing the adhesive from flowing into the space between the solder ribbon and the battery. When a substrate is used to fix the adhesive, the material of the substrate is consistent with the material of the adhesive film, which achieves high light transmittance and improves generated power.

## Description

### CROSS-REFERENCE TO RELATED APPLICATION

The present invention claims the priority of the Chinese patent application with filling number 202211220767.6, titled "CONNECTION STRUCTURE OF CELL AND INTERCONNECT WIRE AND CELL ASSEMBLY THEREFOR", filed to the Chinese Patent Office on October 8, 2022, and the priority of the Chinese patent applications, filed to the Chinese Patent Office on November 11, 2022, with filling number 202211410546.5, titled "BUSBAR-FREE ASSEMBLY"; with filling number 202211410732.9, titled "CONNECTION METHOD OF BUSBAR-FREE CELL AND INTERCONNECT WIRE, AND ASSEMBLY"; and with filling number 202211410735.2, titled "BUSBAR-FREE ASSEMBLY AND MANUFACTURING METHOD", the entire contents of which are incorporated herein by reference.

### TECHNICAL FIELD

The present invention relates to the field of busbar-free assemblies, and specifically to a busbar-free assembly and a manufacturing method therefor, and a method for connecting cell (battery) to interconnect wire (solder ribbon).

### BACKGROUND ART

In photovoltaic power generation, PV modules play the role of receiving sunlight and converting it into electrical energy. In practice, the cell is not a single piece but multiple pieces assembled together to ensure the output power of the assembly. The cell pieces are connected by interconnect wires, wherein an interconnect wire includes an inner copper substrate and an outer solder alloy layer. The solder alloy has a low melting point, which makes it easy to melt. However, neither the solder alloy nor the copper can connect well with the cell itself, resulting in low adhesion. Therefore, the usual practice is to apply silver paste, also known as a busbar, on the cell, and place the interconnect wire on the busbar. The solder alloy can fuse better with the busbar, which improves the bonding strength. However, there is also a problem here: silver paste is relatively expensive and accounts for a significant proportion of the cost of cell assemblies, which amounts to more than 20%. For enterprises, reducing costs while ensuring the efficiency of the power generation and the strength is a goal to pursue. Therefore, how to reduce the amount of silver paste while ensuring connection strength is an urgent problem that persons skilled in the art need to solve.

### SUMMARY

The present invention provides a busbar-free assembly and a manufacturing method therefor, and a method for connecting a cell to an interconnect wire during the manufacturing process of a busbar-free assembly, in order to address at least the problems raised in the above background art.

The embodiments of the present invention provide the following technical solutions. A busbar-free assembly comprises a cell, an interconnect wire arranged on the cell, an adhesive film covering the interconnect wire, and a cover plate covering the adhesive film, and further comprises a bonding mechanism arranged between the interconnect wire and the cell, wherein the bonding mechanism is transparent so as to increase light transmittance for achieving a better light transmission.

Optionally, the bonding mechanism can comprise a light-transmissive adhesive, and the adhesive is capable of bonding the interconnect wire to the cell. The direct use of light-transmissive adhesive eliminates the need for an opaque carrier, which results in higher light transmittance.

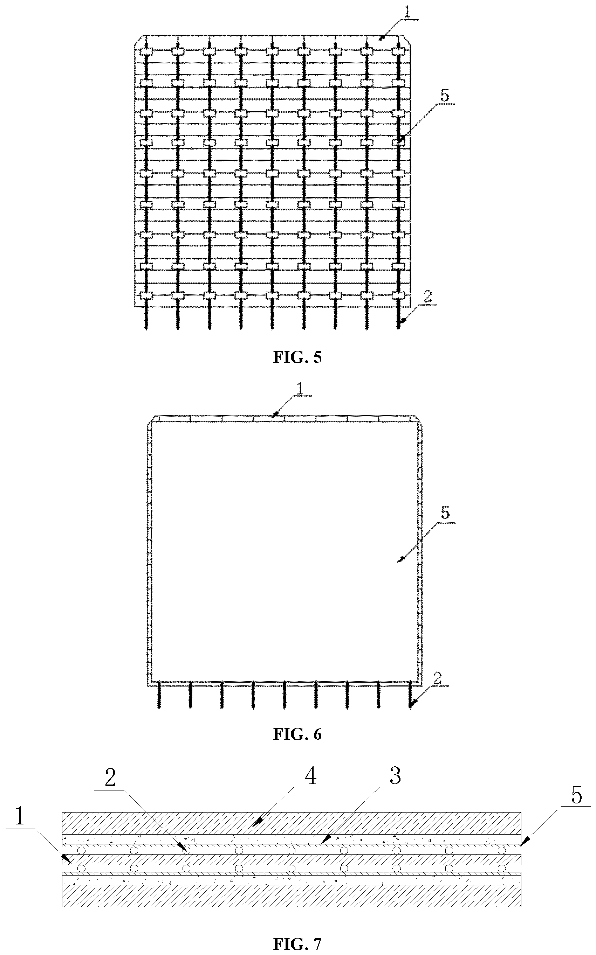

Optionally, the adhesive can be coated on the inner side of the adhesive film, and the size of the adhesive film can correspond to the cell as shown in FIG. 7 to facilitate the fixation of the interconnect wire. Here, the adhesive can be a flowable glue coated on the surface of the adhesive film. Normally, one adhesive film can fix multiple cells. Here, each cell can correspond to one adhesive film, mainly to facilitate the fixation of the interconnect wire by the adhesive film, which eliminates the carrier for the adhesive, thus increasing the light transmittance.

Optionally, the bonding mechanism can also include a transparent substrate for the coating of the adhesive, and the substrate can bond the interconnect wire to the cell through the adhesive.

Optionally, the material of the substrate can be consistent with that of the adhesive film so as to increase light transmittance. The substrate is made of the same material as the adhesive film, which provides good light transmittance and improves the efficiency of light energy conversion.

Optionally, the adhesive can be a pressure-sensitive adhesive or a hot-melt adhesive.

Optionally, the adhesive film is made of EVA (ethyl vinyl acetate), POE (polyolefin elastomer), or PVB (polyvinyl butyral), which has a good light transmission.

Optionally, both the front surface and the back surface of the cell can be provided with an interconnect wire, an adhesive film, and a cover plate, and an upper cover plate can be a light-transmitting glass.

Optionally, the cell can be a high-efficiency cell, which is more efficient and thinner.

Optionally, the interconnect wire can be a low-temperature interconnect wire. The base material in the middle is copper and the outer side is solder alloy, wherein the solder alloy can comprise at least one or more of lead, bismuth, silver, or indium so as to lower the melting point.

Optionally, the adhesive can be arranged, by spraying, on the interconnect wire and the cell for bonding.

The embodiments of the present invention also provide a method for connecting a cell to an interconnect wire during the manufacturing process of a busbar-free assembly, comprising the following steps:
fixation of an interconnect wire and a cell, wherein the interconnect wire is bonded to the cell by using a composite adhesive tape made of a combination of an adhesive and a carrier, with the carrier facilitating the bonding of the adhesive;
removal of the carrier, wherein the carrier is removed, leaving the adhesive, such that the light transmittance is increased when the carrier is removed;
laying of the adhesive film, wherein the adhesive film is coated on the adhesive;
laying of a glass, wherein the glass is laid as a cover plate over the adhesive film;
laminating by a laminating machine, wherein the cell, the interconnect wire, the adhesive, the adhesive film, and the glass are laminated by the laminating machine, so as to form a laminate; and
assembly of components, wherein the laminate is assembled with the relevant components.

Optionally, the adhesive can be a pressure-sensitive adhesive.

In the case where the adhesive is a pressure-sensitive adhesive, optionally, the step of fixation of an interconnect wire and a cell can specifically include the following steps:
connecting the composite adhesive tape to the interconnect wire; and
bonding the connected composite adhesive tape and interconnect wire to the cell.

In the case where the adhesive is a pressure-sensitive adhesive, optionally, the step of fixation of an interconnect wire and a cell can specifically include the following steps:
laying the interconnect wire on the cell; and
bonding the interconnect wire to the cell using the composite adhesive tape.

Optionally, the adhesive is a hot melt adhesive.

In the case where the adhesive is a hot melt adhesive, the step of fixation of an interconnect wire and a cell can specifically include the following steps:
laying the interconnect wire on the cell;
bonding the interconnect wire to the cell using the composite adhesive tape; and
heating to bond the interconnect wire to the cell.

Optionally, the carrier is made of PET.

The embodiments of the present invention also provide a manufacturing method for a busbar-free assembly, comprising the following steps:
laying an interconnect wire, wherein the interconnect wire is laid on a cell;
spraying a glue, wherein the glue is sprayed onto the laid interconnect wire and cell in a manner of spraying, and then the glue forms an adhesive as a bonding mechanism to realize the fixation;
laying an adhesive film, wherein the adhesive film is laid on the adhesive;
laying a cover plate, wherein the cover plate is laid on the adhesive film, thus forming a to-be-laminated piece;
laminating, wherein the to-be-laminated piece is laminated by a laminating machine to form a laminate; and
assembling components, wherein the laminate is assembled with the relevant components.

Optionally, the adhesive can be a pressure-sensitive adhesive.

Optionally, both the front surface and the back surface of the cell can be provided with an interconnect wire, an adhesive film, and a cover plate, and an upper cover plate is a light-transmitting glass.

Optionally, the cell can be a high-efficiency cell, and the interconnect wire can be a low-temperature interconnect wire. The base material in the middle is made of copper and the outer side is made of solder alloy, wherein the solder alloy comprises at least one or more of lead, bismuth, silver, or indium so as to lower the melting point.

Compared with the prior art, the beneficial effects that the present invention can achieve include at least the following beneficial effects.
1. The cell and the interconnect wire are connected by an adhesive, the adhesive is coated on an inner end surface of the adhesive film, and the adhesive film corresponds to the size of the cell, thereby achieving the fixation of the interconnect wire and the cell, thereby omitting a carrier, increasing light transmittance, improving generated power, and also preventing the flow of adhesive between the interconnect wire and the cell. Additionally, using an adhesive for connection ensures strength and reduces costs, thus reducing the risk of aging and yellowing of the flux and other materials due to prolonged outdoor exposure.
2. When a substrate is used to fix the adhesive, the material of the substrate is consistent with the material of the adhesive film, which achieves high light transmittance and improves generated power.
3. The interconnect wire is placed on the cell, the glue is sprayed on the interconnect wire and the adhesive tape in a manner of spraying, and then the adhesive as a bonding mechanism is formed to realize fixation. This is more convenient to operate and can be sprayed on directly, with low requirements for positioning. It is not necessary to pre-fix the interconnect wire, which is simple and convenient, saves labor time, and improves the working efficiency.
4. In the connection method of the cell and the interconnect wire, a composite adhesive tape formed by the adhesive and the carrier is applied to fix the interconnect wire on the cell. After fixing, the carrier is removed, leaving only the adhesive, so as to achieve fixation. This eliminates the carrier and increases light transmittance. Compared to fixing with the adhesive alone, the adhesive operation is facilitated here by the carrier.

### BRIEF DESCRIPTION OF DRAWINGS

FIG. 1 shows a schematic diagram of a connection between a cell and a reinforcing grid according to the present invention;
FIG. 2 shows a structural schematic diagram of the cell and an interconnect wire according to the embodiments of the present invention;
FIG. 3 shows a sectional view of the cell and the interconnect wire according to another embodiment of the present invention;
FIG. 4 shows a structural schematic diagram of the cell and the interconnect wire according to another embodiment of the present invention;
FIG. 5 shows a structural schematic diagram of the cell and the interconnect wire according to another embodiment of the present invention;
FIG. 6 shows a structural schematic diagram of the cell and the interconnect wire according to another embodiment of the present invention;
FIG. 7 shows a structural schematic view of a busbar-free assembly provided in the embodiments of the present invention;
FIG. 8 shows a structural schematic view of the busbar-free assembly according to another embodiment of the present invention;
FIG. 9 shows a top view of the busbar-free assembly shown in FIG. 8;
FIG. 10 shows a flowchart of a manufacturing method for a busbar-free assembly according to the embodiments of the present invention;
FIG. 11 shows a flowchart of a method for connecting a cell to an interconnect wire during a manufacturing process of a busbar-free assembly according to the embodiments of the present invention;
FIG. 12 shows a flowchart for a method for connecting a cell to an interconnect wire during the manufacturing process of a busbar-free assembly according to another embodiment of the present invention; and
FIG. 13 shows a flowchart for a method for connecting a cell to an interconnect wire during the manufacturing process of a busbar-free assembly according to another embodiment of the present invention.

In the figures, 1- cell; 2- interconnect wire; 3- adhesive film; 4- cover plate; 5- adhesive; 6- substrate; 12- finger; 13- auxiliary positioning grid; 14- reinforcing grid; 15- connecting grid.

### DETAILED DESCRIPTION OF EMBODIMENTS

Below will be a clear and complete description of the technical solution in the embodiments of the present invention, in conjunction with the drawings of the embodiments of the present invention. Obviously, the described embodiments are only part of the embodiments of the present invention, not all embodiments. Based on the embodiments of the present invention, all other embodiments obtained by those skilled in the art without inventive effort shall fall within the protection scope of the present invention.

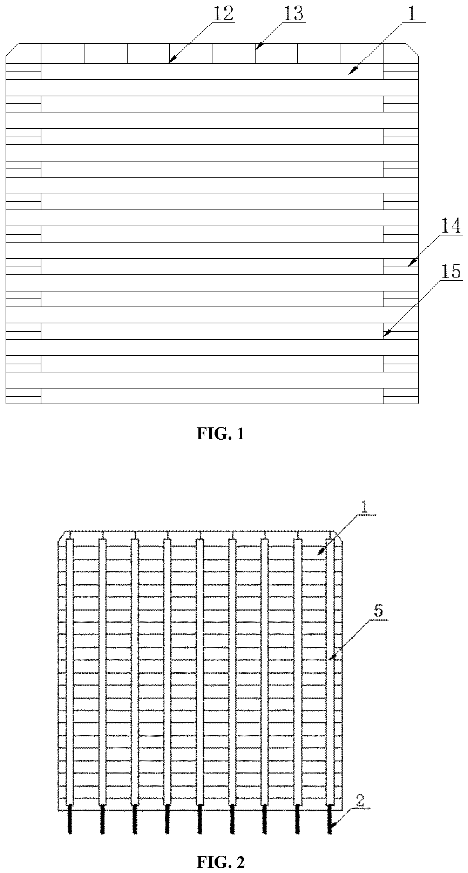

Referring to FIG. 1, the present invention provides a technical solution for a connection structure of a cell and an interconnect wire, and a cell assembly thereof. The connection structure of the cell and the interconnect wire can comprise a cell 1 and multiple parallel interconnect wires 2 arranged on the cell 1, and can also comprise a bonding mechanism provided between the interconnect wires 2 and the cell 1. The bonding mechanism can wrap the interconnect wire 2 from the outside and then later be bonded to the cell 1 so as to fix the interconnect wire 2 to the cell 1. The bonding mechanism secures the interconnect wire 2 to the cell 1 from the outside, thereby eliminating the silver paste and turning the original connection of the interconnect wire to the silver paste into a connection of the interconnect wire to the bonding mechanism. This reduces costs.

The connecting structure of the cell and the interconnect wire according to the embodiments of the present invention can further comprise a finger 12 provided on the cell 1 perpendicular to the interconnect wire 2. The finger 12 can be configured to collect current on the cell 1. The number of fingers 12 on the back surface of the cell 1 can be greater than the number of fingers 12 on the front surface. The cell 1 can be provided with an auxiliary positioning grid 13 for positioning the interconnect wire 2, wherein the auxiliary positioning grid 13 can be perpendicular to the finger 12, and the auxiliary positioning grid 13 can be located on the front surface or the back surface of the cell 1. At least one surface of the front surface or the back surface needs to be provided with the auxiliary positioning grid 13, and the auxiliary positioning grid 13 is provided at the starting end of the interconnect wire 2, without needing to be arranged in the middle. The number of auxiliary positioning grids 13 per row can be 15 to 35, the width of the auxiliary positioning grid 13 can be 0.01 to 0.20 mm, and a height can be 4 to 20 µm. The end of the cell 1 can be provided with a reinforcing grid 14 that is parallel to the finger 12. The reinforcing grid 14 can be located between two adjacent fingers 12 and the reinforcing grid 14 can be located on the outer side of the outermost interconnect wire 2. The inner end of the reinforcing grid 14 can be connected to a connecting grid 15 that is vertical, and both ends of the connecting grid 15 can be connected to the fingers 12 on both sides of the reinforcing grid 14. The reinforcing grid 14 serves to facilitate the collection of current to the outermost interconnect wire 2 and reduces resistance. The connecting grid 15 prevents local breakage and facilitates current flow. Both the reinforcing grid 14 and the connecting grid 15 are made of silver paste. Both the front surface and the back surface of the cell 1 are provided with an interconnect wire 2 and a finger 12.

The interconnect wire 2 can be a low-temperature interconnect wire, wherein the base material in the middle of the low-temperature interconnect wire can be copper and the outer side can be solder alloy. The solder alloy, in addition to tin, can at least include one or more metals such as lead, bismuth, silver, or indium so as to lower the melting point. During lamination, the low-temperature interconnect wire can be directly heated to fuse the interconnect wire 2 with the finger 12, with the melting temperature ranging from 120°C to 160°C. The cell 1 can be a thin-film cell with a thickness range of 70 to 150 µm.

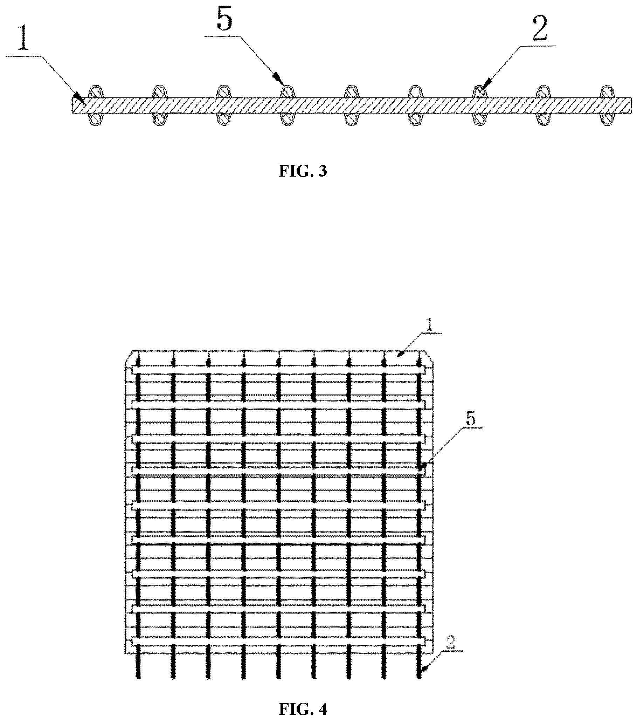

In optional embodiments, as shown in FIGS. 2 and 3, the bonding mechanism can serve as an adhesive 5 of the positioning adhesive tape, and the adhesive 5 wraps around the outside of the interconnect wire 2. Both sides of the adhesive 5 along the length direction can adhere to the cell 1. The adhesive 5 can be a hot-melt adhesive, high-performance pressure-sensitive adhesive, UV-catalyzed adhesive, or a PET substrate with high-performance pressure-sensitive adhesive coated on the end of the PET substrate near the interconnect wire 2, which has a good fixing effect.

In optional embodiments, as shown in FIGS. 2 and 3, the adhesive 5 can be strip-shaped along the length direction of the interconnect wire 2. The adhesive 5 can be provided along the length direction of the interconnect wire 2, and the number of interconnect wires 2 are equal to the number of adhesives 5.

In optional embodiments, as shown in FIG. 4, the adhesive 5 can be strip-shaped and perpendicular to the interconnect wire 2, and the adhesive 5 can span across multiple parallel interconnect wires 2. The adhesive 5 can be perpendicular to the interconnect wire 2 and can span across the interconnect wire 2. One adhesive 5 can fix multiple interconnect wires 2, and multiple adhesives 5 are arranged along the length direction of the interconnect wire 2.

In optional embodiments, as shown in FIG. 5, the adhesive 5 can be block-shaped, and multiple adhesives 5 can be arranged on each interconnect wire 2 along the length direction. The adhesive 5 is square-shaped, multiple of which can be arranged along the length direction of the interconnect wire 2, thus fixing the interconnect wire 2.

In optional embodiments, as shown in FIG. 6, the adhesive 5 can be in the form of a whole block covering all interconnect wires 2. The adhesive 5 can cover all interconnect wires 2, thus achieving complete coverage and increasing tensile strength. This prevents the adhesive film from flowing into the space between the interconnect wire and the adhesive film and causing product defects.

The embodiments of the present invention also provide a busbar-free assembly. In the technical solution of the busbar-free assembly shown in FIG. 7, the busbar-free assembly can include a cell 1, an interconnect wire 2 arranged on the cell 1, an adhesive film 3 covering the interconnect wire 2, and a cover plate 4 covering the adhesive film 3. In some embodiments, the cover plate 4 can be made of glass. The cell 1 can be a high-efficiency cell with high efficiency, and the interconnect wire 2 can be a low-temperature interconnect wire. The base material in the middle of the low-temperature interconnect wire can be copper and the outer side can be solder alloy, wherein the solder alloy can comprise at least one or more of lead, bismuth, silver, or indium so as to lower the melting point. The busbar-free assembly can further comprise a bonding mechanism arranged between the interconnect wire 2 and the cell 1, wherein the bonding mechanism is transparent, so as to increase light transmittance.

The bonding mechanism can comprise a light transmissive adhesive 5, and the adhesive 5 is capable of bonding the interconnect wire 2 to the cell 1. The direct use of light-transmissive adhesive 5 eliminates the need for an opaque carrier, which results in higher light transmittance. The adhesive 5 can be a pressure-sensitive adhesive or a hot-melt adhesive. The adhesive 5 can be coated on the inner side of the adhesive film 3, and the size of the adhesive film 3 can correspond to the cell 1 to facilitate the fixation of the interconnect wire 2. Here, the adhesive 5 can be a flowable glue coated on the surface of the adhesive film 3. Normally, one adhesive film 3 can fix multiple cells 1. Here, each cell 1 can correspond to one adhesive film 3, mainly to facilitate the fixation of the interconnect wire 2 by the adhesive film 3, which eliminates the carrier for the adhesive 5, thus increasing the light transmittance.

In optional embodiments, the glue is sprayed onto the cell 1 and interconnect wire 2 in a manner of spraying, thus forming an adhesive 5 as a bonding mechanism.

The material of the adhesive film 3 can be EVA, POE, or PVB, with good light transmittance. The interconnect wire 2 can be provided on both sides of the cell 1, with both the adhesive film 3 and the cover plate 4 arranged in two layers. In other words, both the front surface and back surface of the cell 1 can be provided with interconnect wires 2, adhesive films 3, and cover plates 4. Optionally, the cover plate 4 upper can be a light-transmitting glass, and the cover plate 4 lower can be a back plate.

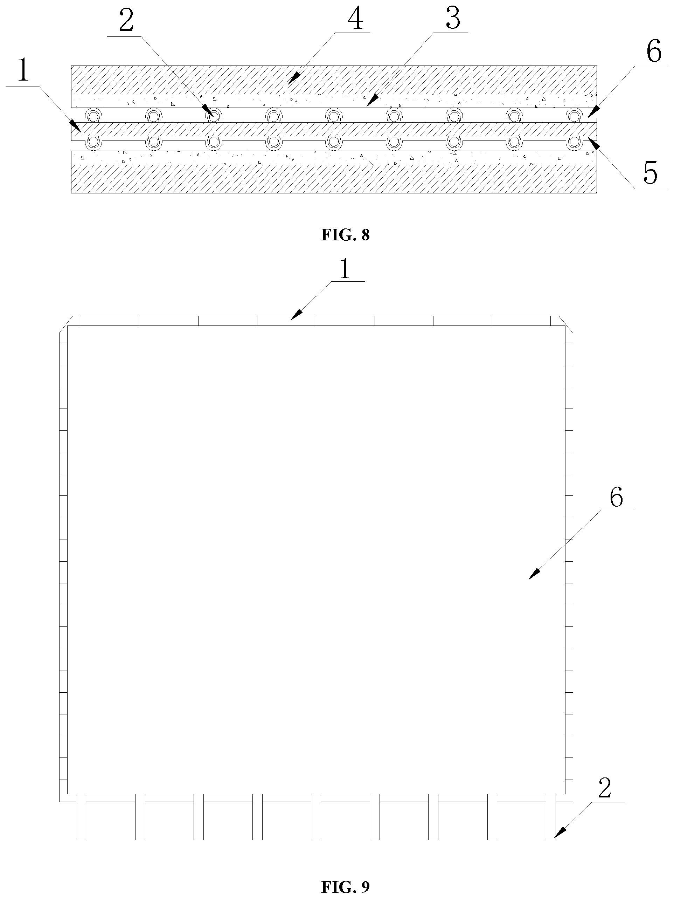

In another embodiment of the present invention providing a technical solution for a busbar-free assembly, as shown in FIGS. 8 to 9, the busbar-free assembly can include a cell 1, an interconnect wire 2 arranged on the cell 1, an adhesive film 3 covering the interconnect wire 2, and a glass covering the adhesive film 3 that serves as the cover plate 4. The cell 1 can be a high-efficiency cell with high efficiency, and the interconnect wire 2 can be a low-temperature interconnect wire. The base material in the middle can be copper and the outer side can be solder alloy, wherein the solder alloy can comprise at least one or more of lead, bismuth, silver, or indium so as to lower the melting point. The busbar-free assembly can further comprise a bonding mechanism arranged between the interconnect wire 2 and the cell 1, wherein the bonding mechanism is transparent, so as to increase light transmittance.

The bonding mechanism can comprise a light transmissive adhesive 5, and the adhesive 5 is capable of bonding the interconnect wire 2 to the cell 1. The direct use of light-transmissive adhesive 5 eliminates the need for an opaque carrier, which results in higher light transmittance. The bonding mechanism can also include a transparent substrate 6 for the coating of the adhesive 5, and the substrate 6 can bond the interconnect wire 2 to the cell 1 through the adhesive 5. The adhesive 5 can be a pressure-sensitive adhesive or a hot-melt adhesive. The material of the adhesive film 3 can be EVA, POE, or PVB, with good light transmittance. The material of the substrate 6 can be consistent with that of the adhesive film 3 so as to increase light transmittance. The substrate 6 is made of the same material as the adhesive film 3, which provides good light transmittance and improves the efficiency of light energy conversion. The interconnect wire 2 can be provided on both sides of the cell 1, and both the adhesive film 3 and the cover plate 4 can be arranged in two layers. In other words, both the front surface and back surface of the cell 1 can be provided with interconnect wires 2, adhesive films 3, and cover plates 4. Optionally, the upper cover plate 4 can be a light-transmitting glass, and the lower cover plate 4 can be a back plate. The substrate 6 here can be a whole block, covering all the interconnect wires 2, or can be strip-shaped covering one or more interconnect wires 2 in parallel or spanning across multiple interconnect wires 2 vertically.

The glue is arranged between the cell 1 and interconnect wire 2 in a manner of spraying, thus forming an adhesive 5 as a bonding mechanism. The working principle is as follows. The cell 1 and the interconnect wire 2 are connected by an adhesive 5, the adhesive 5 is coated on an inner end surface of the adhesive film 3, and the adhesive film 3 corresponds to the size of the cell 1, thereby achieving the fixation of the interconnect wire 2 and the cell 1, thereby omitting a carrier, increasing light transmittance, improving generated power, and also preventing the flow of adhesive between the interconnect wire 2 and the cell 1. When a substrate 6 is used to fix the adhesive 5, the material of the substrate 6 is consistent with the material of the adhesive film 3, which achieves high light transmittance and improves generated power.

The embodiments of the present invention also provide a method for connecting a cell to an interconnect wire during the manufacturing process of a busbar-free assembly.

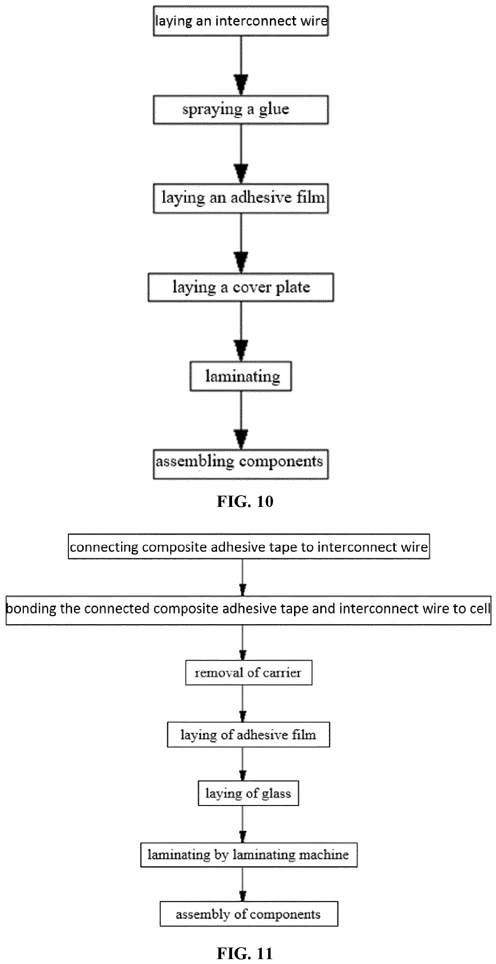

In optional embodiments, as shown in the flowchart of FIG. 11, the method for connecting a cell to an interconnect wire during the manufacturing process of a busbar-free assembly comprises the following steps:
fixation of an interconnect wire 2 and a cell 1, wherein the interconnect wire 2 is bonded to the cell 1 by using a composite adhesive tape made of a combination of an adhesive 5 and a carrier, wherein the adhesive 5 and the carrier are separable, similar to double-sided tape; additionally, the adhesive 5 and the carrier here can be in the form of elongated strips along the interconnect wire, vertical shapes spanning across multiple interconnect wires, or whole pieces covering all the interconnect wires on the cell; the carrier facilitates the adhesion and fixation of the adhesive; the adhesive 5 is a pressure-sensitive adhesive, and the carrier is made of PET, which specifically connects the composite adhesive tape to the interconnect wire 2 and bonds the connected composite adhesive tape and interconnect wire 2 to the cell 1;
removal of the carrier, wherein the carrier is removed, leaving the adhesive 5, such that the light transmittance is increased when the carrier is removed;
laying of the adhesive film 3, wherein the adhesive film 3 is coated on the adhesive 5;
laying of a glass, wherein the glass is laid as a cover plate 4 over the adhesive film;
laminating by a laminating machine, wherein the cell 1, the interconnect wire 2, the adhesive 5, the adhesive film 3, and the glass are laminated by the laminating machine, so as to form a laminate; and
assembly of components, wherein the laminate is assembled with the relevant components.

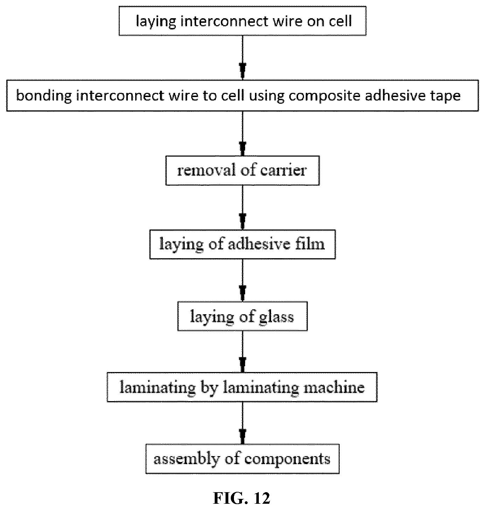

In optional embodiments, as shown in the flowchart of FIG. 12, the method for connecting a cell to an interconnect wire during the manufacturing process of a busbar-free assembly comprises the following steps:
fixation of an interconnect wire 2 and a cell 1, wherein the interconnect wire 2 is bonded to the cell 1 by using a composite adhesive tape made of a combination of an adhesive 5 and a carrier, with the carrier facilitating the bonding of the adhesive, wherein the adhesive 5 is a pressure-sensitive adhesive and the carrier is made of PET, wherein, specifically, the interconnect wire 2 is laid on the cell 1 and the interconnect wire 2 is bonded to the cell 1 by the composite adhesive tape;
removal of the carrier, wherein the carrier is removed, leaving the adhesive, such that the light transmittance is increased when the carrier is removed;
laying of the adhesive film 3, wherein the adhesive film 3 is coated on the adhesive 5;
laying of a glass, wherein the glass is laid as a cover plate 4 over the adhesive film;
laminating by a laminating machine, wherein the cell 1, the interconnect wire 2, the adhesive 5, the adhesive film 3, and the glass are laminated by the laminating machine, so as to form a laminate; and
assembly of components, wherein the laminate is assembled with the relevant components.

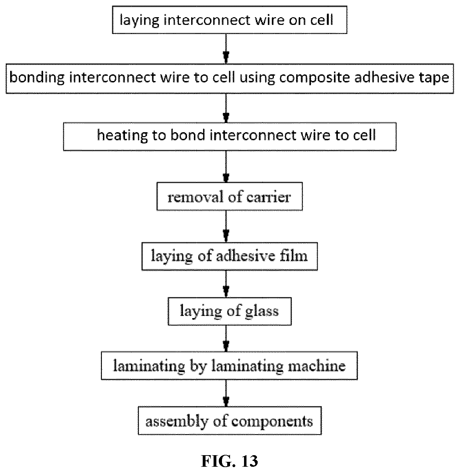

As shown in the flowchart of FIG. 13, the method for connecting a cell to an interconnect wire during the manufacturing process of a busbar-free assembly comprises the following steps:
fixation of an interconnect wire 2 and a cell 1, wherein the interconnect wire 2 is bonded to the cell 1 by using a composite adhesive tape made of a combination of an adhesive 5 and a carrier, with the carrier facilitating the bonding of the adhesive, wherein the adhesive 5 is a hot-melt adhesive and the carrier is made of PET; specifically, the interconnect wire 2 is laid on the cell 1, the interconnect wire 2 is bonded to the cell 1 by the composite adhesive tape, and the interconnect wire 2 is heated to bond to the cell 1;
removal of the carrier, wherein the carrier is removed, leaving the adhesive 5, such that the light transmittance is increased when the carrier is removed;
laying of the adhesive film 3, wherein the adhesive film 3 is coated on the adhesive 5;
laying of a glass, wherein the glass is laid as a cover plate 4 over the adhesive film;
laminating by a laminating machine, wherein the cell 1, the interconnect wire 2, the adhesive 5, the adhesive film 3, and the glass are laminated by the laminating machine, so as to form a laminate; and
assembly of components, wherein the laminate is assembled with the relevant components.

The working principle is as follows. A composite adhesive tape formed by the adhesive 5 and the carrier is applied to fix the interconnect wire 2 on the cell 1. After fixing, the carrier is removed, leaving only the adhesive 5, so as to achieve fixation. This eliminates the carrier and increases light transmittance. Compared to fixing with the adhesive 5 alone, the adhesive operation is facilitated here by the carrier.

The embodiments of the present invention also provide a manufacturing method for a busbar-free assembly.

In optional embodiments, the manufacturing method for a busbar-free assembly as shown in FIG. 10 can include the following steps:
laying an interconnect wire 2, wherein the interconnect wire 2 is laid on a cell 1, wherein the cell 1 can be a high-efficiency cell, and the interconnect wire 2 can be a low-temperature interconnect wire; the base material in the middle is copper and the outer side is solder alloy, wherein the solder alloy can comprise at least one or more of lead, bismuth, silver, or indium so as to lower the melting point.
spraying a glue, wherein the glue is sprayed onto the laid interconnect wire 2 and cell 1 in a manner of spraying, and then the glue forms an adhesive 5 as a bonding mechanism to realize the fixation, wherein the adhesive 5 can be a pressure-sensitive adhesive or a hot-melt adhesive;
laying an adhesive film 3, wherein the adhesive film 3 is laid on the adhesive 5;
laying a cover plate 4, wherein the cover plate 4 is laid on the adhesive film 3, wherein both the front surface and the back surface of the cell 1 can be provided with an interconnect wire 2, an adhesive film 3, and a cover plate 4, and an upper cover plate 4 is a light-transmitting glass, then forming a to-be-laminated piece;
laminating, wherein the to-be-laminated piece is laminated by a laminating machine to form a laminate; and
assembling components, wherein the laminate is assembled with the relevant components.

The working principle is as follows. The interconnect wire 2 is placed on the cell 1, the glue is sprayed on the interconnect wire 2 and the adhesive tape 1 in a manner of spraying, thus forming an adhesive 5 to realize fixation. This is more convenient to operate and can be sprayed on directly, with low requirements for positioning. It is not necessary to pre-fix the interconnect wire 2, which is simple and convenient, saves labor time, and improves the working efficiency.

Although embodiments of the present invention have been illustrated and described, it is understood that those ordinarily skilled in the art can make various changes, modifications, substitutions, and variations to these embodiments without departing from the principles and spirit of the present invention. The scope of the present invention is defined by the appended claims and their equivalents.

### Industrial Practicality

The embodiments of the present invention provide a busbar-free assembly and manufacturing method therefor, and a method for connecting a cell to an interconnect wire. Compared with the prior art, the beneficial effects that the present invention can achieve include at least the following. 1. The cell and the interconnect wire are connected by an adhesive, the adhesive is coated on an inner end surface of the adhesive film, and the adhesive film corresponds to the size of the cell, thereby achieving the fixation of the interconnect wire and the cell, omitting a carrier, increasing light transmittance, improving generated power, and also preventing the flow of adhesive between the interconnect wire and the cell. 2. When a substrate is used to fix the adhesive, the material of the substrate is consistent with the material of the adhesive film, which achieves high light transmittance and improves generated power. 3. The interconnect wire is placed on the cell, the glue is sprayed on the interconnect wire and the adhesive tape in a manner of spraying, and the adhesive of a bonding mechanism is formed to realize fixation; this is more convenient to operate, which can be sprayed on directly, with low requirements for positioning; and it is not necessary to pre-fix the interconnect wire, which is simple and convenient, saves labor time, and improves the working efficiency. 4. In the connection method of the cell and the interconnect wire, a composite adhesive tape formed by the adhesive and the carrier is applied to fix the interconnect wire on the cell; after fixing, the carrier is removed, leaving only the adhesive, so as to achieve fixation; this eliminates the carrier and increases light transmittance; and compared to fixing with the adhesive alone, the adhesive operation is facilitated here by the carrier.

Additionally, it is important to note that a busbar-free assembly and a manufacturing method therefor, and a method for connecting a cell to an interconnect wire provided in the embodiments of the present invention are reproducible and applicable in various industrial applications. For example, a busbar-free assembly and a manufacturing method therefor, and a method for connecting a cell to an interconnect wire provided in the embodiments of the present invention can be used in technical fields relating to busbar-free assemblies.

## Claims

1. A busbar-free assembly, comprising a cell (1), an interconnect wire (2) arranged on the cell (1), an adhesive film (3) covering the interconnect wire (2), and a glass covering the adhesive film (3) that serves as a cover plate (4), **characterized by** further comprising a bonding mechanism arranged between the interconnect wire (2) and the cell (1), wherein the bonding mechanism is transparent so as to increase light transmittance.

2. The busbar-free assembly according to claim 1, wherein the bonding mechanism comprises a light transmissive adhesive (5), and the adhesive (5) is capable of bonding the interconnect wire (2) to the cell (1).

3. The busbar-free assembly according to claim 2, wherein the adhesive (5) is coated on an inner side of the adhesive film (3), and a size of the adhesive film (3) corresponds to the cell (1) to facilitate a fixation of the interconnect wire (2).

4. The busbar-free assembly according to claim 2 or 3, wherein the bonding mechanism further comprises a transparent substrate (6) for a coating of the adhesive (5), and the substrate (6) bonds the interconnect wire (2) to the cell (1) through the adhesive (5).

5. The busbar-free assembly according to claim 4, wherein a material of the substrate (6) is consistent with that of the adhesive film (3) so as to increase light transmittance.

6. The busbar-free assembly according to any one of claims 2 to 5, wherein the adhesive (5) is a pressure-sensitive adhesive or a hot-melt adhesive.

7. The busbar-free assembly according to any one of claims 1 to 6, wherein a material of the adhesive film (3) is EVA, POE, or PVB.

8. The busbar-free assembly according to any one of claims 1 to 7, wherein both a front surface and a back surface of the cell (1) are provided with the interconnect wire (2), the adhesive film (3), and the cover plate (4), and the upper cover plate (4) is a light-transmitting glass.

9. The busbar-free assembly according to any one of claims 1 to 8, wherein the cell (1) is a high-efficiency cell.

10. The busbar-free assembly according to any one of claims 1 to 9, wherein the interconnect wire (2) is a low-temperature interconnect wire.

11. The busbar-free assembly according to any one of claims 2 to 6, wherein the adhesive (5) is arranged on the interconnect wire (2) and the cell (1) by spraying for bonding.

12. A method for connecting a cell to an interconnect wire during a manufacturing process of a busbar-free assembly, **characterized by** comprising following steps:
fixation of the interconnect wire (2) and the cell (1), wherein the interconnect wire (2) is bonded to the cell (1) by using a composite adhesive tape made of a combination of an adhesive (5) and a carrier;
removal of the carrier, wherein the carrier is removed, leaving the adhesive (5);
laying of the adhesive film (3), wherein the adhesive (5) is covered by the adhesive film (3);
laying of a glass, wherein a glass is laid as a cover plate (4) over the adhesive film (3);
laminating by a laminating machine, wherein the cell (1), the interconnect wire (2), the adhesive (5), the adhesive film (3), and the glass are laminated by the laminating machine, so as to form a laminate; and
assembly of components, wherein the laminate is assembled with relevant components.

13. The method for connecting a cell to an interconnect wire according to claim 12, wherein the adhesive (5) is a pressure-sensitive adhesive.

14. The method for connecting a cell to an interconnect wire according to claim 12 or 13, wherein the step of fixation of the interconnect wire (2) and the cell (1) comprises following steps:
connecting the composite adhesive tape to the interconnect wire (2); and
bonding the connected composite adhesive tape and interconnect wire (2) to the cell (1).

15. The method for connecting a cell to an interconnect wire according to claim 12 or 13, wherein the step of fixation of the interconnect wire (2) and the cell (1) comprises following steps:
laying the interconnect wire (2) on the cell (1); and
bonding the interconnect wire to the cell (1) using the composite adhesive tape.

16. The method for connecting a cell to an interconnect wire according to claim 12, wherein the adhesive (5) is a hot-melt adhesive.

17. The method for connecting a cell to an interconnect wire according to claim 16, wherein the step of fixation of the interconnect wire (2) and the cell (1) comprises following steps:
laying the interconnect wire (2) on the cell (1);
bonding the interconnect wire (2) to the cell (1) using the composite adhesive tape; and
heating to bond the interconnect wire (2) to the cell (1).

18. The method for connecting a cell to an interconnect wire according to any one of claims 12 to 17, wherein the carrier is made of PET.

19. A manufacturing method for a busbar-free assembly, **characterized by** comprising following steps:
laying an interconnect wire (2) on a cell (1);
spraying a glue onto a laid interconnect wire (2) and cell (1) by spraying, then the glue forming an adhesive (5) as a bonding mechanism to realize fixation;
laying an adhesive film (3) on the adhesive (5);
laying a cover plate (4) on the adhesive film (3), forming a to-be-laminated piece;
laminating the to-be-laminated piece by a laminating machine to form a laminate; and
assembling the laminate with relevant components.

20. The manufacturing method for a busbar-free assembly according to claim 19, wherein the adhesive (5) is a pressure-sensitive adhesive.

21. The manufacturing method for a busbar-free assembly according to claim 19 or 20, wherein both a front surface and a back surface of the cell (1) are provided with the interconnect wire (2), the adhesive film (3), and the cover plate (4); and the upper cover plate (4) is a light-transmitting glass.

22. The manufacturing method for a busbar-free assembly according to any one of claims 19 to 21, wherein the cell (1) is a high-efficiency cell, and the interconnect wire (2) is a low-temperature interconnect wire.
